# EUROPEAN PATENT SPECIFICATION

(11) **EP 3 961 908 B1**
(45) Date of publication and mention of the grant of the patent: **09.07.2025**
(21) Application number: 20795084.1
(22) Date of filing: 13.03.2020
(51) Int. Cl.: H02P 5/74, H02P 25/16, H05K 7/14

(54) **SERVO AMPLIFIER DEVICE, AND MULTIAXIS SERVO CONTROL DEVICE**
SERVOVERSTÄRKERVORRICHTUNG UND MEHRACHSIGES SERVOSTEUERGERÄT
DISPOSITIF SERVO-AMPLIFICATEUR ET DISPOSITIF DE SERVOCOMMANDE MULTIAXIAL

(30) Priority: 25.04.2019 JP 2019083528
(43) Date of publication of application: 02.03.2022
(73) Proprietor: Panasonic Intellectual Property Management Co., Ltd., Osaka-shi, Osaka 540-6207 (JP)
(72) Inventor: SHIMOGAKI, Yusuke, Osaka-shi, Osaka 540-6207 (JP); TSUKADA, Shota, Osaka-shi, Osaka 540-6207 (JP)
(74) Representative: SSM Sandmair
(86) International application number: PCT/JP2020/011110
(87) International publication number: WO 2020/217765

(56) References cited:
- EP-A2- 2 793 540
- CN-A- 106 602 968
- JP-A- 2014 183 711
- JP-A- 2014 183 711
- JP-A- H08 205 556
- JP-U- H0 657 093
- US-A- 5 493 194

## Description

### TECHNICAL FIELD

The present invention relates to a servo amplifier device that controls and drives a servo motor, and a multiaxis servo control device that includes a plurality of the servo amplifier devices and that control and drive a plurality of the servo motors.

### BACKGROUND ART

As one of use applications of industrial servo motors, there is a processing machine having an arm configured with a plurality of axes. In such a processing machine for controlling multiple axes, usually, a plurality of servo amplifier devices (hereinafter, simply referred to as servo amplifiers, as appropriate) each for controlling and driving a servo motor are also demanded in accordance with a number of axes. For this reason, as the number of axes increases, a servo amplifier group occupies a larger space. Furthermore, wiring connected with the servo motors, wiring for servo amplifier control, and the like also increase. For this reason, a wiring process becomes complicated, and a connection error or the like easily occurs. Therefore, a multiaxis servo drive device having the purpose for, for example, improving work efficiency by simplifying the wiring has been conventionally proposed (see, for example, PTL 1).

Such a conventional multiaxis servo drive device includes a converter unit that outputs DC power, and a plurality of servo amplifier units, each of which drives a servo motor. Each of the units includes a connector for wiring that enables a cable connection for, for example, a DC power supply or a motor power line. Furthermore, the conventional multiaxis servo drive device includes a mount base including a circuit board. On such a circuit board, a receiving-side connector corresponding to a connector of each unit is disposed, and the wiring process is also performed beforehand. The conventional multiaxis servo drive device is configured by disposing each connector of each unit so as to be fitted and connected with the receiving-side connector of the mount base.

In the case of the conventional multiaxis servo drive device, however, in order to hold each unit, a mount base having a rack structure for accommodating each unit in a shelf frame is needed. Therefore, a number of units to be accommodated in the shelf frame is limited, and it is unsuited for a large scale of additional unit installation.

Furthermore, in the conventional multiaxis servo drive device, the provision of a circuit board for the wiring is needed in addition to the rack structure. For this reason, as a configuration for holding each unit, a mount base dedicated to this device is needed. Therefore, it is unsuited to flexibly change the configuration, and the cost also becomes higher.

### Citation List

### Patent Literature

PTL 1: Unexamined Japanese Patent Publication No. 2005-261120
US 5,493,194 A discloses a motor control system and an electrical bus for interconnecting the components of the control system. The system includes a main motor control unit connected to four motor axis control modules. The control algorithms and commands for the system are stored and executed by the control unit which communicates control commands to the individual motor axis control modules. Each motor control module processes the control commands to control a motor connected to the module, and also communicates feedback signals produced at the associated axis to the control unit. The interconnection between the control unit and the modules is positioned at the face of the components to facilitate removal and insertion of the modules. The electrical bus includes both communications conductors and power conductors, and is included in the interconnection of the components. A portion of the system bus is supported by each of the system modules, wherein the bus is completed only if all of the system modules are in position and the connectors of each portion of the bus are engaged.
JP 2014 183711 A discloses a motor driving apparatus including at least one motor driving unit, the motor driving unit includes a drive circuit substrate on which a drive circuit and a control circuit of a motor are mounted and a frame on which the drive circuit substrate is fixed. A power supply circuit substrate on which a power supply circuit for supplying power to the drive circuit substrate is to be mounted and a cover member for covering the power supply circuit substrate can be attached to the X2 direction side of the frame, and in a state where the power supply circuit substrate and the cover member are detached from the frame of a motor driving unit, an X2 direction end of the frame of the motor driving unit can be brought into contact with an X1 direction end of the frame of a motor driving unit.
CN 106 602 968 A discloses a high-power servo motor driving field and especially a servo motor driving unit structure. The servo motor driving unit structure has a special structure. The structure can be used for servo motor driving control, and is formed by function modules and a special housing structure. The housing is a book-type cuboid structure. The top surface and bottom surface of the housing structure are provided with a DC bus duct body, an mBUS interface, an MC_GPIO interface, a speed sensor interface, an MC_CNRLA interface and a motor interface, which are arranged corresponding to the corresponding function modules respectively, thereby realizing corresponding driving control functions and enabling the overall size to be smaller; besides, the overall structure is in a book shape, which facilitates modular production and joint integrated installation with other related unit modules; and the servo motor driving unit structure is of great significance to occasions (such as on a highspeed rail), where installation space is limited.

### SUMMARY OF THE INVENTION

The present invention has been made to address the above drawbacks. In the present invention, a multiaxis servo control device that conducts servo control on a plurality of servo motors constituting multiple axes is achieved with a simple configuration, and has a configuration in consideration of ease of wiring. Accordingly, an object of the present invention is to provide a servo amplifier device and a multiaxis servo control device that also improve work efficiency.

In order to achieve the above object, a servo amplifier device according to the present invention is a servo amplifier device that incorporates a control drive circuit configured to control and drive a motor, the servo amplifier device including: a housing that houses the control drive circuit; an attachment portion for attaching the housing to an installation member; a DC power supply connection unit connected with a DC power supply line to be supplied with DC power; and a communication connector connected with an external controller to be supplied with a communication signal; a motor driving connector connected with a drive line for driving the motor; and a display unit disposed with a display member. The housing has a box shape having a pair of first surfaces facing each other and each having a largest area. The communication connector and the motor driving connector are disposed on a pair of second surfaces perpendicular to the first surfaces and facing each other. On a pair of third surfaces perpendicular to the first surfaces and the second surfaces and facing each other, the attachment portion is disposed on a back surface side with one of the third surfaces being as a back surface, and the display unit and the DC power supply connection unit are disposed on a front surface with the other one of the third surfaces being as the front surface.

With this configuration, the present servo amplifier device has only to be attached on the back surface side. Thus, this configuration eliminates the need for a dedicated installation member such as a rack structure. For example, the housing can be easily attached to a wall or an inexpensive plate-shaped installation member by using the attachment portion. Furthermore, in the case of being installed on an installation member or the like, a number of servo amplifier devices is no longer limited. In addition, the connector or the connection portion is configured to be distributed to the respective surfaces of the housing according to the function. Therefore, the work efficiency together with the ease of the wiring can be improved.

Further, preferably, the DC power supply line is a bus bar including a metal plate, and the DC power supply connection unit is a bus bar connector configured to connect the metal plate of the bus bar.

Further, the DC power supply connection unit is preferably disposed to be closer to a center side than the display unit is on the front surface of the housing.

Further, preferably, the communication connector is disposed on one of the pair of second surfaces, and the motor driving connector is disposed on the other one of the pair of second surfaces.

Further, the display unit is preferably disposed to be closer to the communication connector than the motor driving connector on the front surface of the housing.

Further, a multiaxis servo control device according to the present invention is a multiaxis servo control device including a plurality of the above-described servo amplifier devices and configured to control and drive a plurality of the motors. The present multiaxis servo control device includes a power supply device including a DC power supply output unit that outputs the DC power, and configured to supply the DC power from the DC power supply output unit to each of the servo amplifier devices; an installation board that is the installation member for attaching the power supply device and the plurality of servo amplifier devices; and the DC power supply line that connects the DC power supply connection unit of each of the servo amplifier devices. The plurality of servo amplifier devices are arranged side by side in a normal direction with respect to the first surfaces, and are each attached to the installation board via the attachment portion provided on the back surface side of the housing.

With such a configuration, each servo amplifier device has only to be fixed to an installation member having a simple configuration such as the installation board. Therefore, an additional installation of the servo amplifier device or a change in the arrangement configuration of the servo amplifier devices on the installation board can be easily achieved. Furthermore, in the servo amplifier device, the connectors or the connection portions are distributed according to the function to be disposed on the respective surfaces of the housing. Therefore, the wiring process can also be performed for each function by using a space above or a space below the servo amplifier devices arranged side by side in the lateral direction. Therefore, the wiring becomes easy, and a work error or the like can be suppressed.

Further, preferably, a plurality of split bus bars each including a metal plate as the DC power supply line is further included, and the DC power supply connection units included in the servo amplifier devices adjacent to each other are connected through the split bus bar.

Further, the power supply device according to the present invention includes: a power supply housing that houses a power supply circuit to be supplied with a commercial power supply to generate DC power; a power supply attachment portion for attaching the power supply housing to the installation board; and a DC power supply output unit that outputs the DC power. The power supply housing has a box shape having a pair of first surfaces facing each other and each having a largest area, a commercial power supply input line supplied with the commercial power supply is disposed on a pair of second surfaces perpendicular to the first surfaces and facing each other, on a pair of third surfaces perpendicular to the first surfaces and the second surfaces and facing each other, the power supply attachment portion is disposed on a back surface side with one of the third surfaces being as a back surface, and the DC power supply output unit is disposed on a front surface with the other one of the third surfaces being as the front surface.

Further, preferably, the power supply device and the plurality of servo amplifier devices are disposed side by side in a normal direction with respect to the first surfaces of the housings of the servo amplifier devices, and are each attached to the installation board via the attachment portion provided on the back surface side of the housing of the servo amplifier device.

In this manner, according to the present invention, a multiaxis servo control device that conducts servo control on a plurality of servo motors constituting multiple axes can be achieved with a simple configuration. In addition, it is possible to provide a servo amplifier device having a configuration in consideration of ease of wiring and also improving the work efficiency, and a multiaxis servo control device.

### BRIEF DESCRIPTION OF DRAWINGS

FIG. 1 is a configuration diagram of a multiaxis servo control system including a multiaxis servo control device provided with a plurality of servo amplifier devices according to an exemplary embodiment of the present invention.
FIG. 2 is an external view of the servo amplifier device.
FIG. 3 is a front view illustrating a front surface of the servo amplifier device.
FIG. 4 is a configuration diagram in which a power supply device and the plurality of servo amplifier devices are arranged side by side in a width direction according to the exemplary embodiment of the present invention.

### DESCRIPTION OF EMBODIMENT

An exemplary embodiment of the present invention will be described with reference to the drawings. Note that the following exemplary embodiment is an example embodying the present invention.

### (Exemplary embodiment)

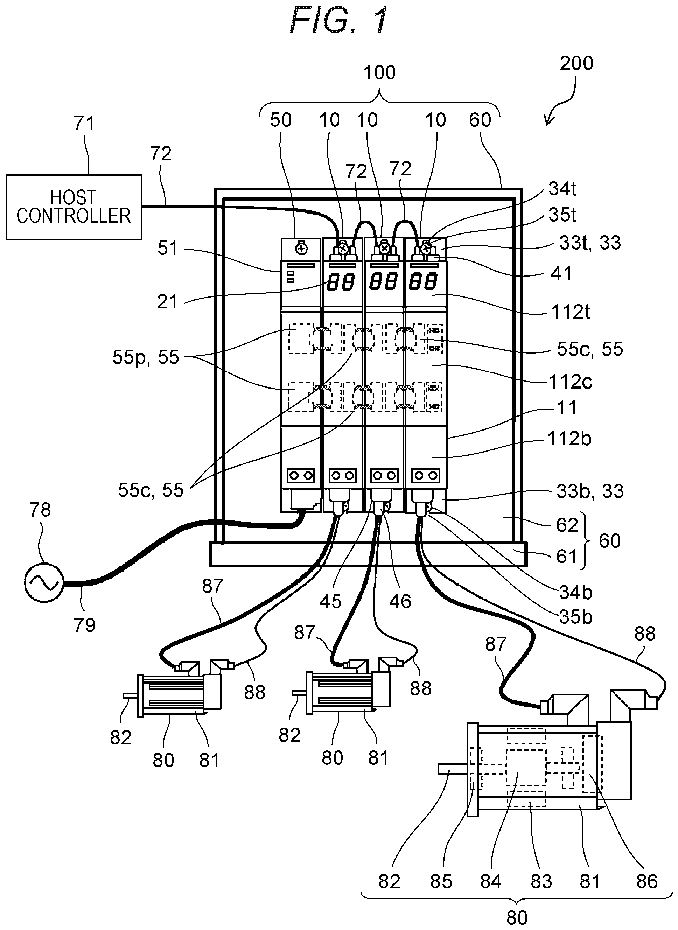

FIG. 1 is a configuration diagram of servo system 200 including multiaxis servo control device 100 provided with a plurality of servo amplifier devices 10 according to an exemplary embodiment of the present invention.

As illustrated in FIG. 1, servo system 200 includes multiaxis servo control device 100, a plurality of servo motors (hereinafter, simply referred to as motors, as appropriate) 80 to be controlled and driven by multiaxis servo control device 100, and host controller 71 that controls each servo amplifier device 10. FIG. 1 illustrates a configuration example of three-axis servo system 200, in which three pairs of servo amplifier devices 10 and motors 80 are provided with one servo amplifier device 10 and one motor 80 constituting one pair.

Multiaxis servo control device 100 in servo system 200 includes three servo amplifier devices 10, power supply device 50 that supplies DC power to each servo amplifier device 10, and installation board 60 on which each servo amplifier device 10 and power supply device 50 are installed.

In servo system 200, first, as motor 80 to be controlled and driven by multiaxis servo control device 100, for example, a brushless motor is suitable in addition to the servo motor. That is, as a configuration example of motor 80, as illustrated by using one of motors 80 in FIG. 1, a brushless motor can be mentioned. Regarding the brushless motor, stator 83 fixed to motor housing 81, rotor 84 disposed on an inner circumferential side of stator 83, and bearing 85 that supports rotor 84 are housed in motor housing 81. Here, stator 83 is formed by winding three-phase windings of a U phase, a V phase, and a W phase around a stator core. Rotor 84 holds a permanent magnet in a rotor core, and rotates about rotation shaft 82. Servo amplifier device 10 applies a drive voltage having a drive waveform corresponding to the control to the windings of motor 80, and then rotation shaft 82 rotates. Accordingly, for example, a load connected with rotation shaft 82 is rotated by motor 80.

In the present exemplary embodiment, the drive voltage for the rotation control as described above is supplied from servo amplifier device 10 to motor 80 via drive line 87. Motor 80 includes encoder 86 for detecting the rotational position of rotor 84. A signal from encoder 86 is supplied to servo amplifier device 10 via encoder line 88.

On the other hand, servo amplifier device 10 incorporates a control drive circuit for controlling and driving motor 80. In order to supply the power to the control drive circuit, multiaxis servo control device 100 includes power supply device 50 for supplying the DC power to each servo amplifier device 10. Power supply device 50 is connected with AC power supply 78, which is a commercial power supply, via commercial power supply input line 79. Power supply device 50 converts AC power supplied from AC power supply 78 into DC power, and supplies the DC power to each servo amplifier device 10. Power supply device 50 houses such a DC power conversion circuit in power supply housing 51 having a box shape. In a similar manner, servo amplifier device 10 also houses the control drive circuit in amplifier housing 11, which is a housing having a box shape. Servo amplifier device 10 uses the DC power that has been supplied from power supply device 50 to cause the control drive circuit to conduct an electrical operation and also generate a drive voltage for driving motor 80.

The present exemplary embodiment is characterized in that the power is supplied by using a so-called bus bar in order to constitute a DC power supply line for supplying the DC power in this manner. The bus bar is a member used to conduct an electric current of a large capacity, and its conductive portion is configured with a conductor plate or a conductor rod formed of a metal such as copper or aluminum. Specifically, regarding the bus bar, as illustrated in FIG. 1, a power supply connection is accomplished by using split bus bars 55 that respectively connect devices to straddle the devices like jumper wires at the central parts on the front surfaces of power supply device 50 and each servo amplifier device 10. Note that the power supply connection using split bus bars 55 will be described later in more detail.

Each servo amplifier device 10 is connected with host controller 71 in order to control the control drive circuit incorporated in each servo amplifier device 10. In FIG. 1, host controller 71 and each servo amplifier device 10 communicate with each other via communication line 72. Note that, in the present exemplary embodiment, an example of wired communication using communication line 72 has been described. However, wireless communication may be configured.

As a specific example of host controller 71, for example, a personal computer can be used in a case of parameter settings or the like, and a programmable logic controller (PLC) or a motion controller can be used in a case of giving an action command for instructing the rotation position, the speed, or the like. Further, as a specific communication method in this communication, for example, data communication compliant with a serial communication standard such as RS232C/485, a universal serial bus (USB) standard, or realtime express (RTEX) or EtherCAT (registered trademark) communication, which is a communication specification dedicated to a factory automation (FA) network, is also suitable. By such a connection between host controller 71 and each servo amplifier device 10, host controller 71 sends various types of information including an action command to each servo amplifier device 10, and also receives various types of information from each servo amplifier device 10, such that motor 80 conducts a desired action. For example, in a case where servo amplifier device 10 controls the position of rotor 84 included in motor 80, host controller 71 notifies of a target position command, and in a case where the speed of rotor 84 is controlled, host controller 71 notifies of a target speed command.

Each servo amplifier device 10 controls and drives the motion and action of motor 80, based on the action command from host controller 71. Therefore, servo amplifier device 10 includes a controller and a drive unit each being as a main circuit configuration. The main operation of the controller includes functions of feedback control as follows. That is, the controller is supplied with a command signal indicating an action command from host controller 71 as described above via communication line 72, and a detection signal indicating the position or speed that has been detected by encoder 86 from encoder 86 of motor 80 via encoder line 88. The controller generates a control signal using such a command signal and such a detection signal, based on, for example, the feedback control, and controls the action of motor 80 such that the motion position or the speed of motor 80 follows the action command. Specifically, the controller is preferably, for example, the central processing unit (CPU) or a microcomputer incorporating a memory in which a program is stored. The drive unit includes a so-called inverter. The inverter is configured with power conversion elements such as a switching element and a diode. The inverter uses these elements to generate a drive voltage having a drive waveform corresponding to the control signal. This drive voltage is supplied to the windings of motor 80 via drive line 87. Accordingly, the windings of motor 80 are energized, and rotor 84 and rotation shaft 82 in motor 80 rotate.

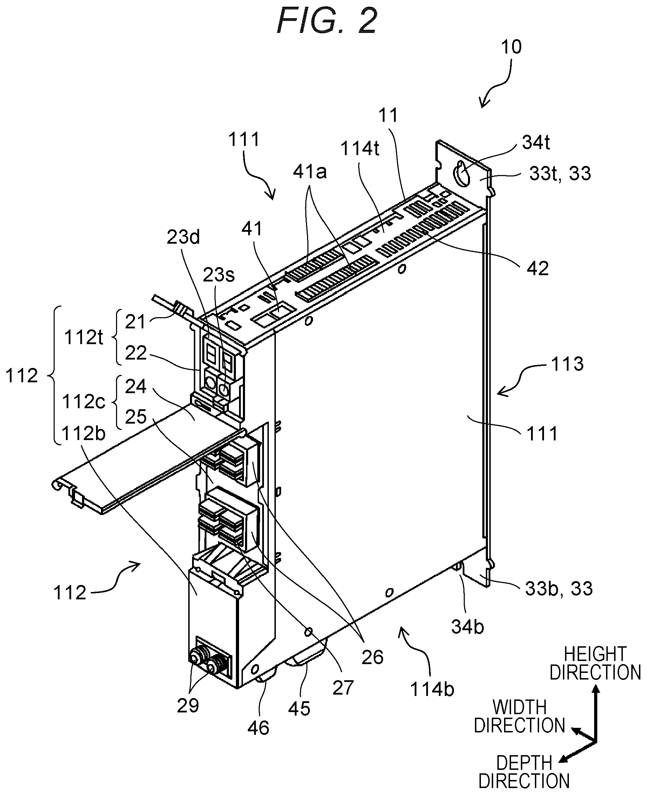

FIG. 2 is an external view of servo amplifier device 10 according to the exemplary embodiment of the present invention.

A configuration of servo amplifier device 10 will be described in detail with reference to FIGS. 1 and 2. As illustrated in FIG. 2, servo amplifier device 10 has a thin box shape in outer appearance. That is, amplifier housing 11 having a rectangular parallelepiped shape with a pair of first surfaces, a pair of second surfaces, and a pair of third surfaces forms a foundation part in the outer appearance of servo amplifier device 10. As illustrated in FIG. 1, the pair of first surfaces are side surfaces 111 each having the largest area. As illustrated in FIG. 1, the pair of second surfaces perpendicular to side surfaces 111, which are the first surfaces, are upper surface 114t and lower surface 114b. As illustrated in FIG. 1, the pair of third surfaces perpendicular to the first surfaces and the second surfaces are front surface 112 and back surface 113.

Hereinafter, a direction in which the pair of side surfaces 111 face each other will be described as a width direction, a direction in which upper surface 114t and lower surface 114b face each other will be described as a height direction, and a direction in which front surface 112 and back surface 113 face each other will be described as a depth direction. In particular, for convenience, in the height direction illustrated in FIG. 2, a side of upper surface 114t will be described as an upper side, and a side of lower surface 114b will be described as a lower side. In a similar manner, in the depth direction, a side of front surface 112 will be described as a front side, and a side of back surface 113 will be described as a back side. Therefore, as illustrated in FIG. 2, servo amplifier device 10 has a box shape in which the height direction and the depth direction are almost the same in the length, and the width direction is thinner than the height direction and the depth direction.

Next, a detailed configuration of the respective surfaces constituting the outer shape of servo amplifier device 10 will be described.

As illustrated in FIG. 1, as a basic configuration of multiaxis servo control device 100, power supply device 50 and each servo amplifier device 10 are arranged in the width direction perpendicular to side surfaces 111 of each servo amplifier device 10. In other words, three servo amplifier devices 10 are arranged side by side in the normal direction with respect to side surfaces 111, which are the first surfaces. Therefore, as illustrated in FIG. 2, in servo amplifier device 10, on both side surfaces 111, basically, no member is configured to be disposed except for a fixing member such as a bolt for fixing a side plate. Both side surfaces 111 are flat surfaces without a protrusion.

In multiaxis servo control device 100, back surfaces 113 of servo amplifier devices 10 are basically fixed. Therefore, attachment portion 33 for fixing servo amplifier device 10 itself to installation board 60 is provided on a side of back surface 113. As an installation member for installing servo amplifier device 10, as illustrated in FIG. 1, installation board 60 is configured with base portion 61 that serves as a base when servo amplifier device 10 is disposed at an installation place, and attachment plate 62 that extends in the height direction from base portion 61 and spreads in a plate shape. In order to fix back surface 113 of servo amplifier device 10 to installation board 60, no member is configured to be disposed on the surface of back surface 113 in a similar manner to side surfaces 111. As illustrated in FIG. 2, attachment portion 33 includes, on the side of back surface 113, upper attachment portion 33t having a small area of a plate shape and extending upward in the height direction from the surface of back surface 113 of amplifier housing 11, and lower attachment portion 33b having a plate shape and extending downward in the height direction. Upper attachment portion 33t and lower attachment portion 33b respectively have attachment holes 34t, 34b to fix servo amplifier device 10 itself to installation board 60 using a fixing member such as a bolt or a screw. On the basis of such a configuration, the surface of back surface 113 of servo amplifier device 10 is aligned with the surface of attachment plate 62 at a predetermined position of attachment plate 62, and bolt or the like is inserted into each of attachment holes 34t, 34b for bolt-fixing. Accordingly, one servo amplifier device 10 is fixed to installation board 60. In FIG. 1, bolt 35t is screwed through attachment hole 34t, and bolt 35b is screwed through attachment hole 34b into attachment plate 62, so as to fix servo amplifier device 10 itself to installation board 60. Further, in attachment plate 62, screw holes are formed beforehand at positions corresponding to respective positions of attachment holes 34t, 34b, so that the work of attaching and detaching servo amplifier device 10 to and from installation board 60 is facilitated. Further, by forming a plurality of such screw holes in the lateral direction (the width direction) of attachment plate 62, an additional installation of servo amplifier device 10 is facilitated.

As illustrated in FIG. 2, in servo amplifier device 10, communication connector 41 is disposed on upper surface 114t of amplifier housing 11. Communication connector 41 is a connector for connecting communication line 72. To communication connector 41, a communication signal is supplied from host controller 71 to servo amplifier device 10 via communication line 72 and communication connector 41. FIG. 2 illustrates an example in which a plurality of types of communication connectors 41 compliant with each communication type or specification are arranged on upper surface 114t. I/O (input/output) connector 41a is disposed on upper surface 114t of amplifier housing 11. I/O connector 41a is used, for example, for inputting or outputting an input signal from each type of switch or sensor or an output signal or the like for driving a relay or the like, which is mounted on a processing machine controlled by the multiaxis servo control device. Furthermore, as illustrated in FIG. 2, heat radiation holes 42 for heat radiation and the like are formed on upper surface 114t of amplifier housing 11.

In servo amplifier device 10, motor driving connector 45 and encoder connector 46 are disposed on lower surface 114b of amplifier housing 11. Motor driving connector 45 is a connector for connecting drive line 87. A drive voltage is supplied from servo amplifier device 10 to motor 80 via motor driving connector 45 and drive line 87. Encoder connector 46 is a connector for connecting encoder line 88. A detection signal indicating a detection position and the like is supplied from motor 80 to servo amplifier device 10 via encoder line 88 and encoder connector 46.

In this manner, in the present exemplary embodiment, the connectors for making connections are disposed separately on the side of upper surface 114t and on the side of lower surface 114b of servo amplifier device 10 depending on the function. Therefore, as can be understood from FIG. 1, an empty space on the side of upper surface 114t is available for each servo amplifier device 10 installed on installation board 60 for wiring of a connection with host controller 71, such as communication line 72. An empty space on the side of lower surface 114b is available for wiring of a connection between drive line 87, encoder line 88, or the like and motor 80. In this manner, in the present exemplary embodiment, regarding the arrangements of the connectors and the space for the wiring process associated with such arrangements, the side of upper surface 114t and the side of lower surface 114b of servo amplifier device 10 are separated depending on the function. Accordingly, ease of wiring is achieved, and work efficiency in line processing is also improved.

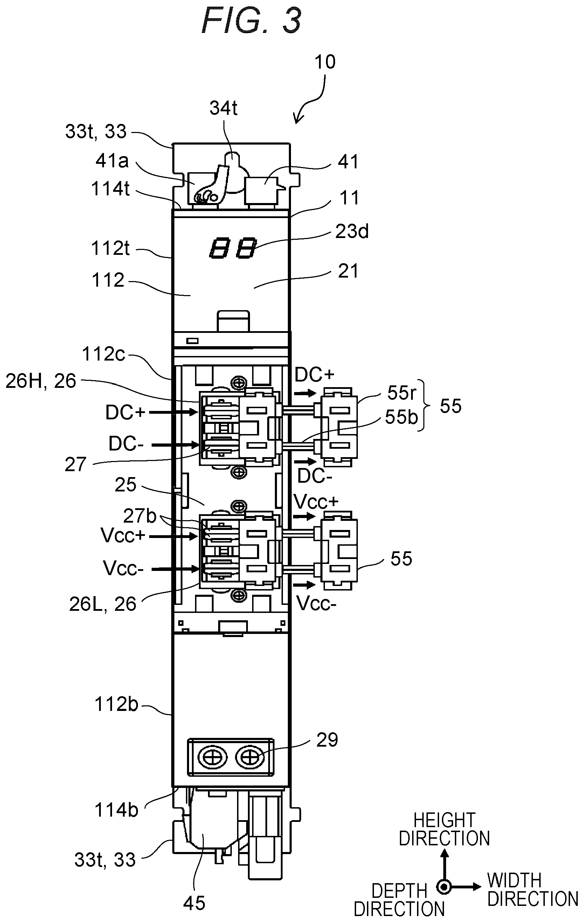

FIG. 3 is a front view illustrating front surface 112 of servo amplifier device 10. A configuration of front surface 112 constituting amplifier housing 11 of servo amplifier device 10 will be described with reference to FIGS. 1, 2, and 3. As illustrated in FIGS. 1 to 3, front surface 112 of amplifier housing 11 is divided into front surface upper portion 112t, front surface middle portion 112c, and front surface lower portion 112b from upper surface 114t to lower surface 114b in the height direction. In brief, on front surface 112, a display unit for displaying information simply with a display member, and a DC power supply connection unit for connecting a DC power supply are disposed. Front surface upper portion 112t serves as an interface area including the display unit. Front surface middle portion 112c, which is closer to the center than the display unit is, serves as an area for power supply distribution that is the DC power supply connection unit.

In front surface lower portion 112b, at its lower part, ground terminal 29 for connecting to the ground is provided. Front surface lower portion 112b has a flat shape except for ground terminal 29.

In front surface upper portion 112t, seven-segment display 23d as a display member is disposed to constitute the display unit. FIGS. 1 to 3 illustrate an example in which two seven-segment displays 23d are disposed.

A more specific configuration of front surface upper portion 112t will be described. Front surface upper portion 112t includes upper door 21, which is transparent and is a vertically openable door. The main body side in the depth direction with respect to upper door 21, which is closed, is defined as member arrangement portion 22, in which a member for a simple interface and the like are arranged. In member arrangement portion 22, a member for device address setting including seven-segment displays 23d and a member for a simple operation by a user are arranged. Upper door 21 is a door that is made of a resin and that is openable and closable in a vertically openable manner. Upper door 21 is openable and closable to rotate vertically around the vicinity of upper surface 114t, when viewed from the lateral direction. An operation unit is attached to member arrangement portion 22 such that an operation for servo amplifier device 10 is enabled with upper door 21 opened. More specifically, member arrangement portion 22 is equipped with rotary switch 23s, a USB connector, and the like, in addition to seven-segment displays 23d. By closing upper door 21, front surface upper portion 112t becomes a flat surface, and as illustrated in FIGS. 1 and 3, the display of seven-segment displays 23d that emit light becomes visible through upper door 21.

In front surface middle portion 112c, as described above, split bus bars 55 that connect the devices are used for constituting the DC power supply line for supplying the DC power so as to supply the power to each servo amplifier device 10. For this reason, in servo amplifier device 10, front surface middle portion 112c serves as DC power supply connection unit 25 to be described next. That is, a bus bar connector configured to connect the metal plate of split bus bar 55 is disposed in DC power supply connection unit 25. More specifically, split bus bar 55 is configured to be an insertion plug type. In front surface middle portion 112c, as bus bar connectors, socket portions 26, into or from which split bus bars 55 are respectively insertable and removable, are provided in the main body of servo amplifier device 10. By inserting split bus bar 55 into socket portion 26, an electrical connection is established.

A more specific configuration of front surface middle portion 112c will be described below. That is, in a similar manner to front surface upper portion 112t, front surface middle portion 112c also includes middle door 24, which is a vertically openable door. The main body side in the depth direction with respect to middle door 24, which is closed, is defined as DC power supply connection unit 25. Socket portions 26 are disposed in DC power supply connection unit 25. Middle door 24 is also an openable and closable door in a vertically openable manner, and is openable and closable to rotate vertically around the vicinity the upper side of front surface middle portion 112c, when viewed from the lateral direction.

In front surface middle portion 112c, two socket portions 26, into each of which split bus bar 55 is insertable and removeable, are disposed. FIG. 1 illustrates a view of servo amplifier device 10 with middle door 24 closed, when viewed from the front surface. In FIG. 1, a state in which split bus bars 55 are respectively attached to socket portions 26 are each indicated by a broken line. FIG. 2 illustrates a state in which no split bus bar 55 is attached. FIG. 3 illustrates a state in which split bus bars 55 are attached only to one sides of both socket portions 26. In the following, a detailed configuration in DC power supply connection unit 25 will be described with reference to these drawings.

One of two socket portions 26 serves as a high-voltage DC power supply. One socket portion 26 is for, for example, rectifying an AC commercial power supply voltage into a DC, and supplying a stabilized DC voltage of a hundred and several tens volts to several hundred volts. This high-voltage DC power is mainly supplied to the drive unit of servo amplifier device 10 to be used for driving motor 80. Another socket portion 26 serves as a low-voltage DC power supply. Another socket portion 26 is, for example, a DC voltage of more than or equal to five volts and less than or equal to 30 volts. This low-voltage DC power is mainly supplied to the controller of servo amplifier device 10 to be used for controlling motor 80.

Socket portion 26 includes a pair of a positive electrode side terminal and a negative electrode side terminal at a DC voltage to be supplied, an input side terminal, and an output side terminal. Socket portion 26 includes four terminals in total.

Specifically, as illustrated in FIG. 3, socket portion 26H, which is socket portion 26 closer to front surface upper portion 112t, is configured for the high-voltage DC power supply, whereas socket portion 26L, which is socket portion 26 closer to front surface lower portion 112b, is configured for the low-voltage DC power supply. In socket portion 26, a pair of terminals on one side in the lateral direction serve as the input side terminal, and a pair of terminals on the other side in the lateral direction serve as the output side terminal. In FIG. 3, a terminal on a side with which no split bus bar 55 is connected is configured as an input side terminal, and a terminal on a side with which split bus bar 55 is connected is configured as an output side terminal. With the present configuration, in socket portion 26H, a high positive voltage DC+ is supplied to a positive electrode terminal on the input side, and a high negative voltage DC-is input into a negative electrode terminal on the input side. The high positive voltage DC+ is output from a positive electrode terminal on the output side, and the high negative voltage DC- is output from a negative electrode terminal on the output side. In a similar manner, in socket portion 26L, a low positive voltage Vcc+ and a low negative voltage Vcc- are input into a terminal on the input side, and the low positive voltage Vcc+ and the low negative voltage Vcc-are output from a terminal on the output side.

As described above, in the present exemplary embodiment, split bus bar 55 is configured to be insertable and removable into and from socket portion 26. In order to enable this insertion and removal, the four terminals in socket portion 26 serve as blade receiving portion 27 having a structure in which two metal plates 27b each having a spring property are brought into face-to-face contact.

To correspond to socket portion 26, split bus bar 55 is configured with two metal bars 55b each being formed of a metal plate, and bar holding portion 55r that holds two metal bars 55b respectively at two positions. As illustrated in FIG. 3, metal bars 55b respectively correspond to the positive side and the negative side of socket portion 26. Bar holding portions 55r respectively correspond to the input side and the output side of socket portion 26. Metal bar 55b includes protruding blades (not illustrated) that protrude from metal bar 55b in a direction opposite to bar holding portion 55r in the vicinity of both ends of each metal bar 55b. That is, by inserting the protruding blade of split bus bar 55 into blade receiving portion 27 of socket portion 26, two metal plates 27b of blade receiving portion 27 sandwich the protruding blade. Accordingly, metal bar 55b and blade receiving portion 27 are electrically connected with each other.

FIG. 3 illustrates a state in which split bus bars 55 are respectively inserted into the output sides of socket portions 26, based on the above configuration. As illustrated in FIG. 3, split bus bar 55 is connected across the output side of certain servo amplifier device 10 and the input side of servo amplifier device 10, which is adjacent. Accordingly, the DC power is supplied between servo amplifier devices 10 adjacent to each other. That is, by sequentially connecting split bus bars 55 in an adjacent direction, the DC power supply line for supplying the DC power to each servo amplifier device 10 can be configured. In this manner, in the present exemplary embodiment, the power supply is configured to be a bus bar type. Therefore, the power supply is enabled in a simple operation of inserting split bus bar 55 without complexity and poor work efficiency in the wiring process, such as entanglement of lines. After insertion of split bus bar 55 is completed, middle door 24 is closed, so that safety such as prevention of electric shock can be easily ensured.

Next, a detailed description will be given with regard to multiaxis servo control device 100 configured by using a plurality of servo amplifier devices 10 each having the above-described configuration.

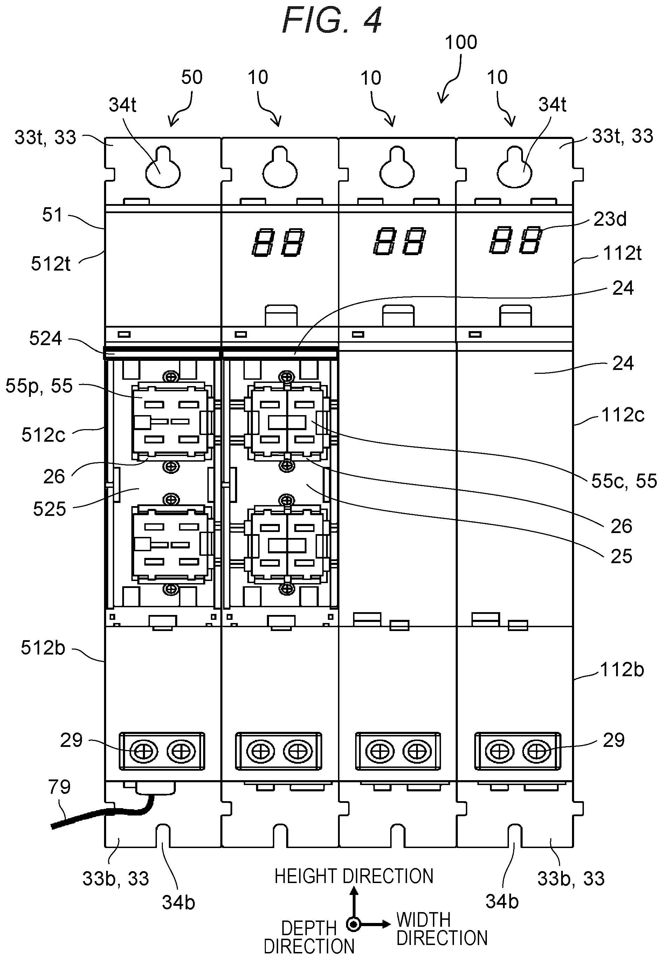

The outline has been described above. As illustrated in FIG. 1, multiaxis servo control device 100 is configured by installing a plurality of servo amplifier devices 10 and one power supply device 50 that supplies the DC power to each of servo amplifier devices 10, on installation board 60. In addition, power supply device 50 and servo amplifier devices 10 have the same dimension in the height direction, power supply device 50 and servo amplifier devices 10 have the same dimension in the depth direction, and power supply device 50 is disposed at an end in the width direction with respect to the plurality of servo amplifier devices 10. FIG. 4 is a configuration diagram in which power supply device 50 and the plurality of servo amplifier devices 10 according to the exemplary embodiment of the present invention are arranged side by side in the width direction.

In such multiaxis servo control device 100, the configuration of each servo amplifier device 10 has been described above. A configuration of power supply device 50 will be described.

As illustrated in FIG. 4, power supply device 50 disposed side by side with respective servo amplifier devices 10 also has a thin box shape in the outer appearance in a similar manner to servo amplifier devices 10. That is, in power supply device 50, power supply housing 51 having a rectangular parallelepiped shape including a pair of first surfaces, a pair of second surfaces, and a pair of third surfaces forms the foundation part in the outer appearance. A power supply circuit that generates the DC power is housed in power supply housing 51. Then, in a similar manner to servo amplifier devices 10, the pair of first surfaces are side surfaces each having the largest area, the second surfaces are the upper surface and the lower surface, and the third surfaces are the front surface and the back surface. FIG. 4 illustrates a state in which power supply device 50 is viewed from the front surface.

In a similar manner to servo amplifier devices 10, both side surfaces of power supply device 50 are basically configured such that no member is disposed except for a fixing member such as a bolt for fixing a side plate. Both side surfaces are flat surfaces without a protrusion. In a similar manner to servo amplifier devices 10, no member is configured to be disposed on the back surface of power supply device 50. Similar to servo amplifier devices 10, attachment portion 33 including upper attachment portion 33t and lower attachment portion 33b is provided as a power supply attachment portion to be attached to the installation member. Upper attachment portion 33t and lower attachment portion 33b respectively have attachment holes 34t, 34b. By inserting a bolt into attachment holes 34t, 34b for bolt-fixing, power supply device 50 is fixed to installation board 60. In power supply device 50, from its lower surface, commercial power supply input line 79 to be connected with AC power supply 78 is drawn out.

Front surface of power supply device 50 has a configuration as illustrated in FIG. 4. In a similar manner to servo amplifier device 10, the front surface of power supply device 50 is also divided into front surface upper portion 512t, front surface middle portion 512c, and front surface lower portion 512b from the upper surface side toward the lower surface side in the height direction. The dimensions in the height direction of front surface upper portion 512t, front surface middle portion 512c, and front surface lower portion 512b also coincide with front surface upper portions 112t, front surface middle portions 112c, and front surface lower portions 112b of servo amplifier devices 10.

In front surface lower portion 512b of power supply device 50, ground terminal 29 is provided at a lower part of front surface lower portion 512b, in a similar manner to servo amplifier devices 10. Front surface lower portion 512b has a flat surface except for ground terminal 29. Power supply device 50 is configured such that nothing is disposed on front surface upper portion 512t, so that front surface upper portion 512t has a flat surface.

As can be understood from the above description, in front surface middle portion 512c of power supply device 50, the DC power is supplied by using split bus bars 55. That is, as illustrated in FIGS. 1 and 4, the DC power supply lines are formed in the width direction in front surface middle portion 512c of power supply device 50 and front surface middle portion 112c of each servo amplifier device 10. The DC power output from power supply device 50 is supplied to each servo amplifier device 10 via the DC power supply lines configured as described above.

Amore specific configuration of front surface middle portion 512c will be described next. That is, power supply device 50 includes middle door 524, which is a vertically openable door, in front surface middle portion 512c. The main body side in the depth direction with respect to middle door 524, which is closed, is defined as DC power supply output unit 525. In a similar manner to servo amplifier devices 10, two socket portions 26 are disposed in DC power supply output unit 525. Note that FIG. 4 illustrates power supply device 50 in a state in which middle door 524 is opened such that DC power supply output unit 525 can be seen. Servo amplifier device 10 adjacent to power supply device 50 indicates a state in which middle door 24 is opened, and two other servo amplifier devices 10 indicate a state in which middle door 24 is closed.

In two socket portions 26 of power supply device 50, one socket portion 26 on the upper side is used for outputting a high-voltage DC power supply, and for example, a DC voltage of a hundred and several tens volts to several hundred volts is output. Another socket portion 26 on the lower side is used for outputting a low-voltage DC power supply, and for example, a DC voltage of more than or equal to five volts to less than or equal to 30 volts is output. In this manner, DC power supply output unit 525 that outputs the DC power using socket portions 26 is disposed in front surface middle portion 512c of power supply device 50.

FIG. 4 illustrates a state in which split bus bars 55 are respectively inserted into socket portions 26 of power supply device 50 and servo amplifier device 10. Here, an example in which socket portion 26 in power supply device 50 is only used for outputting the power supply is illustrated, and split bus bar 55p having a different shape from split bus bar 55c for connecting between servo amplifier devices 10. In the following, a description will be given by also referring to the configuration and the like of blade receiving portion 27 illustrated in FIG. 3. In split bus bar 55c, bar holding portions 55r on both sides respectively correspond to two blade receiving portions 27. In split bus bar 55p, bar holding portion 55r on one side corresponds to four blade receiving portions 27, and bar holding portion 55r on the other side corresponds to two blade receiving portions 27. As illustrated in FIGS. 1 and 4, split bus bar 55p is used for connecting from power supply device 50 to servo amplifier device 10, and split bus bar 55c is used for connecting between servo amplifier devices 10 to constitute the DC power supply line.

As described above, as illustrated in FIG. 1, multiaxis servo control device 100 according to the present exemplary embodiment has a configuration in which power supply device 50 and the plurality of servo amplifier devices 10, which have been described above, are arranged side by side in the width direction on the plate surface of installation board 60, and are attached through bolt-fixing using attachment portion 33. Multiaxis servo control device 100 has such a simple configuration, and thus easily enables an additional installation of servo amplifier device 10 or a change in the arrangement configuration of servo amplifier device 10 on installation board 60. The DC power supply line for supplying the DC power is configured on front surface 512 of power supply device 50 and front surfaces 112 of the plurality of servo amplifier devices 10. Communication connector 41 is disposed on upper surface 114t, and motor driving connector 45 and encoder connector 46 are disposed on lower surface 114b. Therefore, an empty space on the side of upper surface 114t is available for each servo amplifier device 10 for wiring of connection with host controller 71, such as communication line 72. An empty space on the side of lower surface 114b is available for wiring of connection with motor 80, such as drive line 87 or encoder line 88. In this manner, according to the present exemplary embodiment, the wiring process can be performed for each function. Therefore, the wiring becomes easy, and a work error or the like can be suppressed.

As described above, servo amplifier device 10 according to the present exemplary embodiment is servo amplifier device 10 that incorporates a control drive circuit configured to control and drive motor 80, and includes a housing corresponding to amplifier housing 11 that houses the control drive circuit, attachment portion 33 for attaching the housing to an installation member, DC power supply connection unit 25 connected with the DC power supply line to be supplied with DC power, communication connector 41 connected with an external controller corresponding to host controller 71 to be supplied with a communication signal, motor driving connector 45 connected with the drive line that drives motor 80, and the display unit disposed with the display member. The housing has a box shape having a pair of first surfaces 111 facing each other and each having the largest area. Communication connector 41 and motor driving connector 45 are disposed on a pair of second surfaces 114b, 114t, which are perpendicular to first surfaces 111 and which face each other. In a pair of third surfaces 112, 113, which are perpendicular to first surfaces 111 and second surfaces 114b, 114t and which face each other, one of third surfaces 112, 113 is defined as back surface 113, and attachment portion 33 is disposed closer to back surface 113. The other one of third surfaces 112, 113 is defined as front surface 112, and the display unit and DC power supply connection unit 25 are disposed on front surface 112.

With this configuration, this servo amplifier device 10 has only to be attached on a side of back surface 113. Thus, this configuration eliminates the need for a dedicated installation member such as a rack structure. For example, the housing can be easily attached to a wall or an inexpensive plate-shaped installation member by using attachment portion 33. Furthermore, in being installed on an installation member or the like, a number of servo amplifier devices 10 is no longer limited. In addition, the connector or the connection portion is configured to be distributed to the respective surfaces of the housing according to the function. Therefore, the work efficiency together with the ease of the wiring can be improved.

In addition, the DC power supply line is preferably a bus bar including a metal plate, and DC power supply connection unit 25 is a bus bar connector configured to connect the metal plate of the bus bar.

Further, DC power supply connection unit 25 is preferably disposed to be closer to the center side than the display unit is on front surface 112 of the housing.

Further, preferably, communication connector 41 is disposed on one surface of the pair of second surfaces 114b, 114t, and motor driving connector 45 is disposed on the other one of the pair of second surfaces 114b, 114t.

Further, the display unit is preferably disposed to be closer to communication connector 41 than motor driving connector 45 on front surface 112 of the housing.

Further, multiaxis servo control device 100 according to the present exemplary embodiment is a multiaxis servo control device 100 including a plurality of servo amplifier devices 10 and configured to control and drive a plurality of motors 80. This multiaxis servo control device 100 includes power supply device 50 including DC power supply output unit 525 that outputs the DC power, and configured to supply the DC power from DC power supply output unit 525 to each of servo amplifier devices 10, installation board 60, which is the installation member for attaching power supply device 50 and the plurality of servo amplifier devices 10; and the DC power supply line that connects DC power supply connection unit 25 of each of servo amplifier devices 10. The plurality of servo amplifier devices 10 are arranged side by side in a normal direction with respect to first surfaces 111, and are each attached to installation board 60 via attachment portion 33 provided closer to back surface 113 of the housing.

With such a configuration, each servo amplifier device 10 has only to be fixed to the installation member having a simple configuration such as installation board 60. Therefore, an additional installation of servo amplifier device 10 or a change in the arrangement configuration of servo amplifier devices 10 on the installation board can be easily achieved. Furthermore, in servo amplifier device 10, connectors or connection portions are distributed according to the function to be disposed on the respective surfaces of the housing. Therefore, the wiring process can also be performed for each function, by using a space above or a space below servo amplifier devices 10 arranged in the lateral direction. Therefore, the wiring becomes easy, and a work error or the like can be suppressed.

In addition, preferably, a plurality of split bus bars 55 each including a metal plate as the DC power supply line is further included, and DC power supply connection units 25 included in servo amplifier devices 10 adjacent to each other are connected through split bus bar 55.

Further, power supply device 50 according to the present exemplary embodiment includes power supply housing 51, which houses a power supply circuit to be supplied with a commercial power supply to generate DC power, a power supply attachment portion corresponding to attachment portion 33 for attaching power supply housing 51 to installation board 60, and DC power supply output unit 525 that outputs the DC power. Power supply housing 51 has a box shape having a pair of first surfaces 111 facing each other and each having a largest area, commercial power supply input line 79 to be supplied with the commercial power supply is disposed on a pair of second surfaces 114b, 114t perpendicular to first surfaces 111 and facing each other, on a pair of third surfaces 112, 113 perpendicular to first surfaces 111 and second surfaces 114b, 114t and facing each other, the power supply attachment portion is disposed closer to back surface 113 with one of third surfaces 112, 113 being as back surface 113, and DC power supply output unit 525 is disposed on front surface 112 with the other one of third surfaces 112, 113 being as front surface 112.

Further, preferably, power supply device 50 and the plurality of servo amplifier devices 10 are disposed side by side in a normal direction with respect to first surfaces 111, and are each attached to the installation board via attachment portion 33 provided closer to back surface 113 of the housing.

In this manner, according to the present exemplary embodiment, multiaxis servo control device 100 that performs servo control on the plurality of servo motors constituting multiple axes is achieved with a simple configuration. In addition, servo amplifier device 10 and multiaxis servo control device 100 in which work efficiency is improved by a configuration in consideration of ease of wiring can be provided.

### INDUSTRIAL APPLICABILITY

A servo amplifier device and a multiaxis servo control device in the present invention are capable of controlling and driving a multiaxis motor with an easy configuration. Therefore, the present invention is useful for, for example, a semiconductor manufacturing apparatus and an electronic component mounting machine.

### REFERENCE MARKS IN THE DRAWINGS

10: servo amplifier device
11: amplifier housing
21: upper door
22: member arrangement portion
23d: seven-segment display
23s: rotary switch
24, 524: middle door
25: DC power supply connection unit
26, 26H, 26L: socket portion
27: blade receiving portion
27b: metal plate
29: ground terminal
33: attachment portion
33b: lower attachment portion
33t: upper attachment portion
34b, 34t: attachment hole
35b, 35t: bolt
41: communication connector
41a: I/O connector
42: heat radiation hole
45: motor driving connector
46: encoder connector
50: power supply device
51: power supply housing
55, 55c, 55p: split bus bar
55b: metal bar
55r: bar holding portion
60: installation board
61: base portion
62: attachment plate
71: host controller
72: communication line
78: AC power supply
79: commercial power supply input line
80: motor
81: motor housing
82: rotation shaft
83: stator
84: rotor
85: bearing
86: encoder
87: drive line
88: encoder line
100: multiaxis servo control device
111: side surface (first surface)
112, 512: front surface (third surface)
112t, 512t: front surface upper portion
112b, 512b: front surface lower portion
112c, 512c: front surface middle portion
113: back surface (third surface)
114b: lower surface (second surface)
114t: upper surface (second surface)
200: servo system
525: DC power supply output unit

## Claims

1. A servo amplifier device (10) that incorporates a control drive circuit configured to control and drive a motor (80), the servo amplifier device (10) comprising:
a housing that houses the control drive circuit;
an attachment portion (33) for attaching the housing to an installation member;
a DC power supply connection unit (25) connected with a DC power supply line to be supplied with DC power;
a communication connector (41) connected with an external controller to be supplied with a communication signal;
a motor driving connector (45) connected with a drive line (87) for driving the motor (80); and
a display unit disposed with a display member,
wherein
the housing has a box shape having a pair of first surfaces (111) facing each other and each having a largest area,
the communication connector (41) and the motor driving connector (45) are disposed on a pair of second surfaces (114b, 114t) perpendicular to the first surfaces (111) and facing each other,
on a pair of third surfaces (112, 113) perpendicular to the first surfaces (111) and the second surfaces (114b, 114t) and facing each other, the attachment portion (33) is disposed on a back surface (113) side with one of the third surfaces (112, 113) being as a back surface (113), and
the display unit and the DC power supply connection unit (25) are disposed on a front surface (112) with another one of the third surfaces (112, 113) being as the front surface (112).

2. The servo amplifier device (10) according to claim 1, wherein
the DC power supply line is a bus bar including a metal plate, and
the DC power supply connection unit (25) is a bus bar connector configured to connect the metal plate of the bus bar.

3. The servo amplifier device (10) according to claim 1, wherein the DC power supply connection unit (25) is disposed to be closer to a center side than the display unit is on the front surface (112) of the housing.

4. The servo amplifier device (10) according to claim 1, wherein the communication connector (41) is disposed on one of the pair of second surfaces (114b, 114t), and the motor driving connector (45) is disposed on another one of the pair of second surfaces (114b, 114t).

5. The servo amplifier device (10) according to claim 1, wherein the display unit is disposed to be closer to the communication connector (41) than the motor driving connector (45) on the front surface of the housing.

6. A multiaxis servo control device (100) comprising a plurality of the servo amplifier devices (10) according to any one of claims 1 to 5, and configured to control and drive a plurality of the motors (80), the multiaxis servo control device (100) comprising:
a power supply device (50) including a DC power supply output unit (525) that outputs the DC power, and configured to supply the DC power from the DC power supply output unit (525) to each of the plurality of the servo amplifier devices (10);
an installation board (60) that is the installation member for attaching the power supply device (50) and the plurality of the servo amplifier devices (10); and
the DC power supply line that connects the DC power supply connection unit (25) of each of the plurality of the servo amplifier devices (10), wherein the plurality of the servo amplifier devices (10) are arranged side by side in a normal direction with respect to the first surfaces (111), and are attached to the installation board (60) via the attachment portion (33) provided on the back surface (113) side of the housing.

7. The multiaxis servo control device (100) according to claim 6, further comprising a plurality of split bus bars (55) each including a metal plate as the DC power supply line,
wherein the DC power supply connection units (25) included in the servo amplifier devices (10) adjacent to each other are connected through each of the plurality of split bus bars (55).

8. The multiaxis servo control device (100) according to claim 6, wherein
the power supply device (50) includes:
a power supply housing (51) that houses a power supply circuit to be supplied with a commercial power supply to generate DC power;
a power supply attachment portion for attaching the power supply housing (51) to the installation board (60); and
a DC power supply output unit (525) that outputs the DC power,
the power supply housing (51) has a box shape having a pair of first surfaces (111) facing each other and each having a largest area,
a commercial power supply input line (79) to be supplied with the commercial power supply is disposed on a pair of second surfaces (114b, 114t) perpendicular to the first surfaces (111) of the power supply housing (51) of the power supply device (50) and facing each other,
on a pair of third surfaces (112, 113) perpendicular to the first surfaces (111) of the power supply housing (51) of the power supply device (50) and the second surfaces (114b, 114t) of the power supply housing (51) of the power supply device (50) and facing each other, the power supply attachment portion is disposed on a back surface (113) side of the power supply housing (51) of the power supply device (50) with one of the third surfaces (112, 113) of the power supply housing (51) of the power supply device (50) being as a back surface (113), and
the DC power supply output unit is disposed on a front surface (112) of the power supply housing (51) of the power supply device (50) with another one of the third surfaces (112, 113) of the power supply housing (51) of the power supply device (50) being as the front surface.

9. The multiaxis servo control device (100) according to claim 8, wherein the power supply device (50) and the plurality of the servo amplifier devices (10) are disposed side by side in a normal direction with respect to the first surfaces (111) of the housings of the plurality of the servo amplifier devices (10), and are each attached to the installation board (60) via the attachment portion (33) provided on the back surface (113) side of the housing of each of the plurality of the servo amplifier device (10).

## Patentansprüche

1. Servoverstärkervorrichtung (10), die eine Antriebssteuerungsschaltung umfasst, die zum Steuern und Antreiben eines Motors (80) konfiguriert ist, wobei die Servoverstärkervorrichtung (10) Folgendes umfasst:
ein Gehäuse, in dem die Antriebssteuerungsschaltung untergebracht ist;
einen Befestigungsabschnitt (33) zum Befestigen des Gehäuses an einem Installationselement;
eine Gleichstromversorgungs-Anschlusseinheit (25), die zur Versorgung mit Gleichstrom mit einer Gleichstromversorgungsleitung verbunden ist;
eine Kommunikationsverbindung (41), die mit einer externen Steuerung verbunden ist, um mit einem Kommunikationssignal versorgt zu werden;
eine Motorantriebsverbindung (45), die mit einer Antriebsleitung (87) zum Antrieb des Motors (80) verbunden ist; und
eine Anzeigeeinheit, die mit einem Anzeigeelement ausgestattet ist,
wobei
das Gehäuse eine Kastenform mit einem Paar einander zugewandter erster Oberflächen (111) hat, von denen jede eine größte Fläche aufweist,
die Kommunikationsverbindung (41) und die Motorantriebsverbindung (45) auf einem Paar zweiter Oberflächen (114b, 114t) angeordnet sind, die senkrecht zu den ersten Oberflächen (111) stehen und einander zugewandt sind,
auf einem Paar dritter Oberflächen (112, 113), die senkrecht zu den ersten Oberflächen (111) und den zweiten Oberflächen (114b, 114t) stehen und einander zugewandt sind, der Befestigungsabschnitt (33) auf einer Rückseite (113) angeordnet ist, wobei eine der dritten Oberflächen (112, 113) als Rückseite (113) dient, und
die Anzeigeeinheit und die Gleichstromversorgungs-Anschlusseinheit (25) auf einer Vorderseite (112) angeordnet sind, wobei eine andere der dritten Oberflächen (112, 113) als Vorderseite (112) dient.

2. Servoverstärkervorrichtung (10) nach Anspruch 1, wobei
die Gleichstromversorgungsleitung eine Sammelschiene mit einer Metallplatte ist, und
die Gleichstromversorgungs-Anschlusseinheit (25) eine Sammelschienenverbindung ist, die zum Verbinden der Metallplatte der Sammelschiene konfiguriert ist.

3. Servoverstärkervorrichtung (10) gemäß Anspruch 1, wobei die Gleichstromversorgungs-Anschlusseinheit (25) näher an einer Mittelseite angeordnet ist als die Anzeigeeinheit auf der Vorderseite (112) des Gehäuses.

4. Servoverstärkervorrichtung (10) gemäß Anspruch 1, wobei die Kommunikationsverbindung (41) auf einer der beiden zweiten Oberflächen (114b, 114t) angeordnet ist und die Motorantriebsverbindung (45) auf einer anderen der beiden zweiten Oberflächen (114b, 114t) angeordnet ist.

5. Servoverstärkervorrichtung (10) nach Anspruch 1, wobei die Anzeigeeinheit näher am Kommunikationsanschluss (41) als der Motorantriebsanschluss (45) auf der Vorderseite des Gehäuses angeordnet ist.

6. Mehrachsiges Servosteuergerät (100), das eine Vielzahl der Servoverstärkervorrichtungen (10) gemäß einem der Ansprüche 1 bis 5 umfasst und dazu konfiguriert ist, eine Vielzahl der Motoren (80) zu steuern und anzutreiben, wobei das mehrachsige Servosteuergerät (100) Folgendes umfasst:
eine Stromversorgungsvorrichtung (50), die eine Gleichstromversorgungs-Ausgangseinheit (525) umfasst, die den Gleichstrom abgibt, und die so konfiguriert ist, dass sie den Gleichstrom von der Gleichstromversorgungs-Ausgangseinheit (525) an jede aus der Vielzahl von Servoverstärkervorrichtungen (10) liefert;
eine Installationsplatte (60), die das Installationselement zum Anbringen der Stromversorgungsvorrichtung (50) und der Vielzahl der Servoverstärkervorrichtungen (10) ist; und
die Gleichstromversorgungsleitung, die die Gleichstromversorgungs-Anschlusseinheit (25) jedes aus der Vielzahl von Servoverstärkergeräten (10) verbindet, wobei die Vielzahl von Servoverstärkergeräten (10) in einer Normalrichtung in Bezug auf die ersten Oberflächen (111) nebeneinander angeordnet sind und über den Befestigungsabschnitt (33), der auf der Rückseite (113) des Gehäuses vorgesehen ist, an der Installationsplatte (60) befestigt sind.

7. Mehrachsiges Servosteuergerät (100) nach Anspruch 6, das ferner eine Vielzahl von geteilten Sammelschienen (55) umfasst, die jeweils eine Metallplatte als Gleichstromversorgungsleitung umfassen.
wobei die in den Servoverstärkervorrichtungen (10) enthaltenen Gleichstromversorgungs-Anschlusseinheiten (25) nebeneinander durch jede der Vielzahl von geteilten Sammelschienen (55) verbunden sind.

8. Mehrachsiges Servosteuergerät (100) nach Anspruch 6, wobei
die Stromversorgungseinrichtung (50) umfasst:
ein Stromversorgungsgehäuse (51), das eine Stromversorgungsschaltung aufnimmt, die mit einer kommerziellen Stromversorgung versorgt wird, um Gleichstrom zu erzeugen;
einen Netzteil-Befestigungsabschnitt zum Befestigen des Netzteilgehäuses (51) an der Installationsplatte (60); und
eine Gleichstromversorgungs-Ausgangseinheit (525), die den Gleichstrom abgibt, wobei
das Netzteilgehäuse (51) eine Kastenform mit einem Paar erster Oberflächen (111) hat, die einander zugewandt sind und jeweils eine größte Fläche aufweisen,
eine mit der kommerziellen Stromversorgung zu versorgende Netzstrom-Eingangsleitung (79) auf einem Paar zweiter Flächen (114b, 114t) angeordnet ist, die senkrecht zu den ersten Flächen (111) des Stromversorgungsgehäuses (51) der Stromversorgungsvorrichtung (50) stehen und einander zugewandt sind,
auf einem Paar dritter Oberflächen (112, 113), die senkrecht zu den ersten Oberflächen (111) des Stromversorgungsgehäuses (51) der Stromversorgungsvorrichtung (50) und den zweiten Oberflächen (114b, 114t) des Stromversorgungsgehäuses (51) der Stromversorgungsvorrichtung (50) verlaufen und einander zugewandt sind, der Stromversorgungsbefestigungsabschnitt auf einer Seite der hinteren Oberfläche (113) des Stromversorgungsgehäuses (51) der Stromversorgungsvorrichtung (50) angeordnet ist, wobei eine der dritten Oberflächen (112, 113) des Stromversorgungsgehäuses (51) der Stromversorgungsvorrichtung (50) als Rückfläche (113) dient, und
die Gleichstromversorgungs-Ausgangseinheit auf einer Vorderfläche (112) des Stromversorgungsgehäuses (51) der Stromversorgungsvorrichtung (50) angeordnet ist, wobei eine andere der dritten Flächen (112, 113) des Stromversorgungsgehäuses (51) der Stromversorgungsvorrichtung (50) die Vorderfläche ist.

9. Mehrachsiges Servosteuergerät (100) gemäß Anspruch 8, wobei die Stromversorgungsvorrichtung (50) und die Vielzahl der Servoverstärkervorrichtungen (10) in einer Normalrichtung nebeneinander in Bezug auf die ersten Oberflächen (111) der Gehäuse der Vielzahl der Servoverstärkervorrichtungen (10) angeordnet sind und jeweils über den Befestigungsabschnitt (33), der auf der Rückseite (113) des Gehäuses jeder der Vielzahl der Servoverstärkervorrichtungen (10) vorgesehen ist, an der Installationsplatte (60) befestigt sind.

## Revendications

1. Dispositif servo-amplificateur (10) qui incorpore un circuit d'entraînement de commande configuré pour commander et entraîner un moteur (80), le dispositif servo-amplificateur (10) comprenant:
un boîtier qui loge le circuit d'entraînement de commande;
une portion de fixation (33) pour fixer le boîtier à un élément d'installation ;
une unité de connexion d'alimentation CC (25) connectée à une ligne d'alimentation CC afin de recevoir de la puissance CC ;
un connecteur de communication (41) connecté à un dispositif de commande externe afin de recevoir un signal de communication ;
un connecteur d'entraînement de moteur (45) connecté à une ligne d'entraînement (87) pour entraîner le moteur (80) ; et
une unité d'affichage disposée avec un élément d'affichage, dans lequel
le boîtier présente une forme de boîte ayant une paire de premières surfaces (111) se faisant face et ayant chacune une aire la plus grande,
le connecteur de communication (41) et le connecteur d'entraînement de moteur (45) sont disposés sur une paire de deuxièmes surfaces (114b, 114t) perpendiculaires aux premières surfaces (111) et se faisant face,
sur une paire de troisièmes surfaces (112, 113) perpendiculaires aux premières surfaces (111) et aux deuxièmes surfaces (114b, 114t) et se faisant face, la portion de fixation (33) est disposée sur un côté surface arrière (113), l'une des troisièmes surfaces (112, 113) servant de surface arrière (113), et
l'unité d'affichage et l'unité de connexion d'alimentation CC (25) sont disposées sur une surface avant (112), une autre des troisièmes surfaces (112, 113) étant la surface avant (112).

2. Dispositif servo-amplificateur (10) selon la revendication 1, dans lequel
la ligne d'alimentation CC est une barre omnibus incluant une plaque en métal, et
l'unité de connexion d'alimentation CC (25) est un connecteur de barre omnibus configuré pour connecter la plaque en métal de la barre omnibus.

3. Dispositif servo-amplificateur (10) selon la revendication 1, dans lequel l'unité de connexion d'alimentation CC (25) est disposée de sorte à être plus proche d'un côté central que l'unité d'affichage ne l'est sur la surface avant (112) du boîtier.

4. Dispositif servo-amplificateur (10) selon la revendication 1, dans lequel le connecteur de communication (41) est disposé sur l'une de la paire de deuxièmes surfaces (114b, 114t), et le connecteur d'entraînement de moteur (45) est disposé sur une autre de la paire de deuxièmes surfaces (114b, 114t).

5. Dispositif servo-amplificateur (10) selon la revendication 1, dans lequel l'unité d'affichage est disposée de sorte à être plus proche du connecteur de communication (41) que le connecteur d'entraînement de moteur (45) sur la surface avant du boîtier.

6. Dispositif de servocommande multiaxial (100) comprenant une pluralité des dispositifs servo-amplificateurs (10) selon l'une quelconque des revendications 1 à 5, et configuré pour commander et entraîner une pluralité des moteurs (80), le dispositif de servocommande multiaxial (100) comprenant :
un dispositif d'alimentation (50) incluant une unité de sortie d'alimentation CC (525) qui fournit en sortie la puissance CC, et configuré pour fournir la puissance CC à partir de l'unité de sortie d'alimentation CC (525) à chacun de la pluralité des dispositifs servo-amplificateurs (10) ;
une carte d'installation (60) qui est l'élément d'installation pour fixer le dispositif d'alimentation (50) et la pluralité des dispositifs servo-amplificateurs (10) ; et
la ligne d'alimentation CC qui connecte l'unité de connexion d'alimentation CC (25) de chacun de la pluralité des dispositifs servo-amplificateurs (10), dans lequel la pluralité des dispositifs servo-amplificateurs (10) sont agencés côte à côte dans une direction normale par rapport aux premières surfaces (111), et sont fixés à la carte d'installation (60) par l'intermédiaire de la portion de fixation (33) prévue sur le côté surface arrière (113) du boîtier.

7. Dispositif de servocommande multiaxial (100) selon la revendication 6, comprenant en outre une pluralité de barres omnibus (55) divisées incluant chacune une plaque en métal en tant que ligne d'alimentation CC,
dans lequel les unités de connexion d'alimentation CC (25) incluses dans les dispositifs servo-amplificateurs (10) adjacents les uns aux autres sont connectées par le biais de chacune de la pluralité de barres omnibus (55) divisées.

8. Dispositif de servocommande multiaxial (100) selon la revendication 6, dans lequel
le dispositif d'alimentation (50) inclut :
un boîtier d'alimentation (51) qui loge un circuit d'alimentation devant recevoir de la puissance commerciale pour générer de la puissance CC ;
une portion de fixation d'alimentation pour fixer le boîtier d'alimentation (51) à la carte d'installation (60) ; et
une unité de sortie d'alimentation CC (525) qui fournit en sortie la puissance CC,
le boîtier d'alimentation (51) présente une forme de boîte ayant une paire de premières surfaces (111) se faisant face et ayant chacune une aire la plus grande,
une ligne d'entrée d'alimentation commerciale (79) devant recevoir la puissance commerciale est disposée sur une paire de deuxièmes surfaces (114b, 114t) perpendiculaires aux premières surfaces (111) du boîtier d'alimentation (51)du dispositif d'alimentation (50) et se faisant face,
sur une paire de troisièmes surfaces (112, 113) perpendiculaires aux premières surfaces (111) du boîtier d'alimentation (51) du dispositif d'alimentation (50) et aux deuxièmes surfaces (114b, 114t) du boîtier d'alimentation (51) du dispositif d'alimentation (50) et se faisant face, la portion de fixation d'alimentation est disposée sur un côté de surface arrière (113) du boîtier d'alimentation (51) du dispositif d'alimentation (50), l'une des troisièmes surfaces (112, 113) du boîtier d'alimentation (51) du dispositif d'alimentation (50) servant de surface arrière (113), et
l'unité de sortie d'alimentation CC est disposée sur une surface avant (112) du boîtier d'alimentation (51) du dispositif d'alimentation (50), une autre des troisièmes surfaces (112, 113) du boîtier d'alimentation (51) du dispositif d'alimentation (50) servant de surface avant.

9. Dispositif de servocommande multiaxial (100) selon la revendication 8, dans lequel le dispositif d'alimentation en courant (50) et la pluralité des dispositifs servo-amplificateurs (10) sont disposés côte à côte dans une direction normale par rapport aux premières surfaces (111) des boîtiers de la pluralité des dispositifs servo-amplificateurs (10), et sont chacun fixés à la carte d'installation (60) par l'intermédiaire de la portion de fixation (33) prévue sur le côté surface arrière (113) du boîtier de chacun de la pluralité des dispositifs servo-amplificateurs (10).
